(19) Europäisches Patentamt
European Patent Office
Office européen des brevets

(11) EP 2 554 394 B1

(12) # EUROPEAN PATENT SPECIFICATION

(45) Date of publication and mention of the grant of the patent:
**24.04.2019 Bulletin 2019/17**

(21) Application number: **11759262.6**

(22) Date of filing: **15.03.2011**

(51) Int Cl.:
***G03F 7/031*** *(2006.01)* ***G03F 7/11*** *(2006.01)*
***G03F 7/038*** *(2006.01)* ***B41C 1/10*** *(2006.01)*
***G03F 7/30*** *(2006.01)* *G03F 7/033 (2006.01)*

(86) International application number:
**PCT/JP2011/056086**

(87) International publication number:
**WO 2011/118456 (29.09.2011 Gazette 2011/39)**

(54) **PLANOGRAPHIC PRINTING MASTER PLATE AND PRODUCTION METHOD THEREFOR**

FLACHDRUCK-MASTERPLATTE UND HERSTELLUNGSVERFAHREN DAFÜR

PLAQUE MAÎTRESSE D’IMPRESSION PLANOGRAPHIQUE ET PROCÉDÉ DE PRODUCTION ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2010 JP 2010073868**

(43) Date of publication of application:
**06.02.2013 Bulletin 2013/06**

(73) Proprietor: **FUJIFILM Corporation**
**Tokyo 106-0031 (JP)**

(72) Inventors:
- **MORI, Takanori**
**Haibara-gun, Shizuoka (JP)**
- **HAYASHI, Kenji**
**Haibara-gun, Shizuoka (JP)**
- **HASHIGAYA, Manabu**
**Haibara-gun, Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A1- 2 042 337** **EP-A2- 1 992 482**
**WO-A1-2008/156552** **JP-A- 2 103 051**
**JP-A- 10 062 969** **JP-A- 2005 280 123**
**JP-A- 2008 284 858** **JP-A- 2009 056 733**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 554 394 B1

## Description

### TECHNICAL FIELD

The present invention relates to a negative-working lithographic printing plate precursor which is capable of undergoing image-recording with laser and contains a polymerizable compound, and a method of producing thereof. More particularly, it relates to a negative-working lithographic printing plate precursor capable of undergoing on-press development having an oxygen-blocking overcoat layer on an image-recording layer containing a polymerizable compound, and a method of producing thereof.

### BACKGROUND ART

Direct plate making in which a lithographic printing plate precursor is directly subjected to scanning exposure with a visual laser beam or an infrared laser beam to conduct plate making has been commercially carried out in recent years.

One of the lithographic printing plate precursors for use in the direct plate making is a photopolymerization type lithographic printing plate precursor having a photopolymerizable image-recording layer containing a sensitizing dye, a polymerization initiator and a polymerizable compound, as an image-recording layer.

When the photopolymerization type lithographic printing plate precursor is exposed with a laser beam, in the area irradiated with the laser beam of the photopolymerizable image-recording layer an ethylenically unsaturated compound is cured by polymerization, thereby forming a printing image.

However, since a radical generated from the polymerization initiator by the exposure is deactivated by oxygen in the air, the polymerization reaction is inhibited to cause insufficient curing and as a result a problem arises in that an image can not be formed or even when an image is formed, the image is insufficient in its printing durability. Thus, in the photopolymerization type lithographic printing plate precursor, an oxygen-blocking layer comprising an oxygen-impermeable resin, for example, polyvinyl alcohol is ordinarily formed on a surface of the photopolymerizable image-recording layer to protect the photopolymerizable image-recording layer from oxygen in the air (Patent Documents 1 to 5).

Also, in an on-press development type lithographic printing plate precursor which is subjected to development on a printing machine, an overcoat layer (protective layer) is ordinarily provided on the image-recording layer in order to prevent the occurrence of scratch or the like in the image-recording layer, to block oxygen or to prevent ablation at the time of laser exposure of high illuminance. However, the effect of increasing printing durability is small and there is a problem in that ink receptivity is deteriorated.

It is also conducted that the oxygen-blocking property is increased by incorporating an inorganic stratiform compound having a high aspect ratio into an overcoat layer to make up for the printing durability (Patent Document 6). However, the printing durability is yet insufficient and the ink receptivity further decreases and thus the improvement has been requested.

### PRIOR ART DOCUMENT

### PATENT DOCUMENT

Patent Document 1: JP-B-7-60268
Patent Document 2: JP-A-9-34117
Patent Document 3: JP-A-9-204049
Patent Document 4: JP-A-11-311862
Patent Document 5: JP-A-2002-169272
Patent Document 6: JP-A-2005-119273

EP 2 042 337 A1 discloses a lithographic printing plate precursor which comprises: a support; a photosensitive layer (image-forming layer) on the support which contains a synthetizing dye, a polymerization initiator and a polymerizable compound; and a protective layer provided on the photosensitive layer, wherein the protective layer is laminated on the photosensitive layer.

JP 2005-280123 discloses a lithographic printing plate precursor which comprises: a support; and a photosensitive layer (image-forming layer) on the support which contains a sensitizing dye, a polymerization initiator and a polymerizable compound and an unexposed area of which is capable of being removed by supplying, after exposure, at least one of printing ink and dampening water on a printing machine, wherein the precursor is provided with a laminate film.

DISCLOSURE OF THE INVENTION PROBLEMS THAT THE INVENTION IS TO SOLVE AND MEANS FOR SOLVING THE PROBLEMS

An object of the present invention is to provide a lithographic printing plate precursor excellent in printing durability and ink receptivity in accordance with present claim 1.

In particular, it is to provide a lithographic printing plate precursor in which the overcoat layer is formed on the image-recording layer by dry lamination in accordance with present claim 6.

ADVANTAGE OF THE INVENTION

According to the present invention, an on-press development type lithographic printing plate precursor excellent in ink receptivity and printing durability and a method of producing thereof can be provided.

MODE FOR CARRYING OUT THE INVENTION

The present invention will be described in detail below.

First, the overcoat layer for use in the lithographic printing plate precursor according to the invention is described.

[Overcoat layer]

The water-soluble resin which is incorporated into the overcoat layer of the lithographic printing plate precursor according to the invention is not particularly restricted as long as it is capable of forming a uniform film which adheres to the image-recording layer.

Specifically, for instance, a water-soluble polymer, for example, polyvinyl alcohol, a modified polyvinyl alcohol, polyvinyl pyrrolidone, polyvinyl imidazole, polyacrylic acid, polyacrylamide, a partially saponified product of polyvinyl acetate, an ethylene-vinyl alcohol copolymer, a water-soluble cellulose derivative, gelatin, a starch derivative or gum arabic, and a polymer, for example, polyvinylidene chloride, poly(meth)acrylonitrile, polysulfone, polyvinyl chloride, polyethylene, polycarbonate, polystyrene, polyamide or cellophane are exemplified. The polymers may be used in combination of two or more kinds thereof, if desired.

Of the polymers, from the standpoint of easy removability of the protective layer remaining in the non-image area and handling property at the time of forming the layer, for example, polyvinyl alcohol, polyvinyl pyrrolidone, polyvinyl imidazole, a water-soluble acrylic resin, for example, polyacrylic acid, gelatin or gum arabic is preferred. Above all, polyvinyl alcohol, polyvinyl pyrrolidone, gelatin or gum arabic is more preferred from the standpoint of easiness of removal with dampening water at the printing.

The polyvinyl alcohol for use in the overcoat layer according to the invention may be partially substituted with an ester, an ether or an acetal as long as it contains a substantial amount of unsubstituted vinyl alcohol units necessary for maintaining water solubility. Also, the polyvinyl alcohol may partially contain other copolymerization components. Specific examples of the polyvinyl alcohol include those being hydrolyzed 71 to 100% by mole and having a polymerization degree in a range from 300 to 2,400.

Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd. are exemplified.

As the copolymer described above, polyvinyl acetate chloroacetate or propionate, polyvinyl formal and polyvinyl acetal and copolymers thereof each hydrolyzed from 88 to 100% by mole are exemplified.

The amount of the water-soluble resin added is preferably 20% by weight or more, more preferably 30% by weight or more, still more preferably 50% by weight or more, based on the total solid content of the overcoat layer.

According to the invention, the overcoat layer may contain an inorganic stratiform compound together with the water-soluble resin. The inorganic stratiform compound is a particle having a thin tabular shape and includes, for instance, a mica, for example, natural mica represented by the following formula: A $(B, C)_{2-5}$ $D_4$ $O_{10}$ $(OH, F, O)_2$, (wherein A represents any of Li, K, Na and Ca, B and C each represents any of Fe (II), Fe(III), Mn, Al, Mg and V, and D represents Si or Al) or synthetic mica, talc represented by the following formula: $3MgO \cdot 4SiO \cdot H_2O$, taeniolite, montmorillonite, saponite, hectorite and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilicic mica $KMg_{2.5}(Si_4O_{10})F_2$, and swellable mica, for example, Na tetrasilicic mica $NaMg_{2.5}(Si_4O_{10})F_2$, Na or Li taeniolite $(Na, Li)Mg_2Li(Si_4O_{10})F_2$, or montmorillonite-based Na or Li hectorite $(Na, Li)_{1/8}Mg_{2/5}Li_{1/8}(Si_4O_{10})F_2$. Synthetic smectite is also useful.

In the invention, of the inorganic stratiform compounds, mica is preferred and fluorine-based swellable mica,

which is a synthetic inorganic stratiform compound, is particularly useful. Specifically, the swellable synthetic mica and a swellable clay mineral, for example, montmorillonite, saponite, hectorite or bentonite have a laminate structure comprising a unit crystal lattice layer having thickness of approximately from 10 to 15 angstroms, and metallic atom substitution in the lattices thereof is remarkably large in comparison with other clay minerals. As a result, the lattice layer results in lack of positive charge and to compensate it, a cation, for example, $Li^+$, $Na^+$, $Ca^{2+}$ or $Mg^{2+}$ is adsorbed between the lattice layers. The cation existing between the lattice layers is referred to as an exchangeable cation and is exchangeable with various cations. Particularly, in the case where the cation between the layers is $Li^+$ or $Na^+$, since the ionic radius is small, the bond between the stratiform crystal lattices is weak, thereby greatly swelling with water. When share is applied under such a condition, the stratiform crystal lattices are easily cleaved to form a stable sol in water. The bentonite and swellable synthetic mica strongly show this tendency and are useful in the invention and in particular, the swellable synthetic mica is preferably used.

As for the shape of the inorganic stratiform compound for use in the invention, from the standpoint of control of diffusion, the thickness is preferably smaller and as long as the smoothness of the coated surface and the transmission of actinic radiation are not damaged, the plane size is preferably larger. Therefore, an aspect ratio is preferably 20 or more, more preferably 100 or more, and particularly preferably 200 or more. The aspect ratio is a ratio of major axis to thickness of particle and can be determined, for example, from a projection drawing of particle by a microphotography. As the aspect ratio is larger, the effect obtained is higher.

As for a particle diameter of the inorganic stratiform compound for use in the invention, an average major axis is preferably from 0.3 to 20 $\mu$m, more preferably from 0.5 to 10 $\mu$m, and particularly preferably from 1 to 5 $\mu$m. Also, an average thickness of the particle is 0.1 $\mu$m or less, preferably 0.05 $\mu$m or less, and particularly preferably 0.01 $\mu$m or less. For example, with respect to the swellable synthetic mica that is the representative compound of the inorganic stratiform compound, the thickness is approximately from 1 to 50 nm and the plain size is approximately from 1 to 20 $\mu$m.

When such an inorganic stratiform compound particle having a large aspect ratio is incorporated into the overcoat layer, strength of the coated layer increases and penetration of oxygen or moisture can be effectively inhibited and thus, the overcoat layer can be prevented from deterioration due to deformation, and even when the lithographic printing plate precursor is preserved for a long period of time under a high humidity condition, deterioration of the image-forming property in the lithographic printing plate precursor due to the change of humidity is prevented and the excellent preservation stability is obtained.

The content of the inorganic stratiform compound in the overcoat layer is preferably from 5/1 to 1/100 in terms of weight ratio to the amount of the water-soluble resin used in the overcoat layer. When a plurality of inorganic stratiform compounds is used in combination, it is also preferred that the total amount of the inorganic stratiform compounds fulfills the above-described weight ratio.

Ordinarily, the exposure is performed in the air according to the invention. The overcoat layer prevents a low molecular weight compound, for example, oxygen or a basic substance present in the air, which inhibits the image-forming reaction occurred upon the exposure in the image-recording layer from penetrating into the image-recording layer and as a result, the inhibition of image-forming reaction at the exposure in the air can be restrained. Accordingly, the characteristic required of the overcoat layer is to reduce permeability of the low molecular weight compound, for example, oxygen. Further, the overcoat layer preferably has good transparency to light used for the exposure, is excellent in an adhesion property to the image-recording layer, and can be easily removed during the on-press development processing step after the exposure. With respect to the overcoat layer having such properties, various investigations have been made heretofore and there are described in detail, for example, in U.S. Patent 3,458,311 and JP-B-55-49729.

[Interlayer mixing between image-recording layer and overcoat layer]

It is estimated that the results that even when an overcoat layer is provided, the effect of increasing printing durability is small and the problem in that ink receptivity is deteriorated arises are caused by the fact that at the stage of coating and drying of a coating solution for overcoat layer the overcoat layer component is mixed with the image-recording layer and the optimal functions of the image-recording layer and overcoat layer can not be achieved. Specifically, it is estimated that the ink receptivity and printing durability become insufficient in comparison with the case where the interlayer mixing does not occur.

According to the invention, it is characterized in that the image-recording layer and overcoat layer are substantially not mixed. The terminology "the image-recording layer and overcoat layer are substantially not mixed" means that a mixing ratio of the overcoat layer to the image-recording layer defined below is 10% or less. In the range, deteriorations of ink receptivity and printing durability are prevented. The mixing ratio of the overcoat layer to the image-recording layer is more preferably 5% or less.

An existing amount of the overcoat layer which does not undergo the interlayer mixing is preferably from 0.01 to 2 $g/m^2$, more preferably from 0.02 to 1 $g/m^2$, and particularly preferably from 0.02 to 0.5 $g/m^2$.

[Definition and measuring method of interlayer mixing ratio]

A lithographic printing plate precursor obtained is exposed after vacuuming at 30 mmHg using an UV exposure machine so as that a reaction rate of polymerizable group reaches 60% or more. The reaction rate of polymerizable group is measured by FT-IR. Specifically, an amount of polymerizable group remained after the exposure and an amount of polymerizable group exiting before the exposure are determined by FT-IR and a rate of polymerizable group reacted by the exposure (reaction rate of polymerizable group) is determined.

Then, the exposed lithographic printing plate precursor is washed with water at 25°C while rubbing with an absorbent cotton and an amount of overcoat layer dissolved is determined as an amount (A) of overcoat layer which does not undergo the interlayer mixing in terms of weight per $m^2$. An interlayer mixing ratio (%) of overcoat layer is calculated from this value using a formula shown below. In the formula, a total overcoat layer amount (B) is a total amount of overcoat layer existing when the interlayer mixing does not occur and is determined in a manner shown below.

An overcoat layer is provided on a support (for example, a PET film, a polypropylene film or a glass substrate) and a weight ($\alpha$) of the overcoat layer and support is measured. Then, the coating is washed with water at 25°C while rubbing with an absorbent cotton to completely remove the overcoat layer and a weight ($\beta$) of the coating is measured. A value of ($\alpha$) - ($\beta$) is determined and calculated in terms of weight per $m^2$ to obtain the total overcoat layer amount (B).

$$\text{Interlayer mixing ratio (\%) of overcoat layer} = [1-((A)/(B))] \times 100$$

[Laminating method of overcoat layer]

The method of forming the overcoat layer uses a system of laminating without intervention of solvent or paste in which a form of film is maintained (in the invention, this system is defined as a dry laminating system).

The dry laminating of the overcoat layer on image-recording layer is carried out in the manner described below. Specifically, the overcoat layer is coated on a temporary support and dried. As the temporary support, a support which does not repel a coating solution for overcoat layer and from which the overcoat layer can be released and a support having a critical surface tension ranging from 25 to 40 mN/m is preferred. Specifically, a material, for example, polypropylene, polyethylene, polyethylene terephthalate or polystyrene is exemplified, and polypropylene is preferred.

A coating method to the temporary support is not particularly restricted. For instance, a coating method, for example, a casting coating (precast coating) system, a gravure coating method, a roll coating method, a spray coating method or a bar coating method, or an extrusion coating method of molten material (for example, a method of forming a film by melt extrusion using a die or a method in which the film formed is further subjected to stretching) is exemplified.

In case of coating as a solution by adding a solvent, after the coating a film is dried under high temperature by hot air or the like. Since water is used as the solvent in order to dissolve the water-soluble resin contained in the overcoat layer, it is ordinarily preferred to be dried at drying temperature from 100 to 150°C. When the drying temperature is lower than 100°C, it takes time for the drying and when it is higher than 150°C, the temporary support may undergo deformation. The drying temperature is more preferably from 105 to 125°C.

The overcoat layer provided on the temporary support is subjected to humidity conditioning preferably at temperature from 15 to 30°C and relative humidity from 50 to 90%. The condition is more preferably at temperature from 18 to 28°C and relative humidity from 55 to 85%, and particularly preferably at temperature from 20 to 25°C and relative humidity from 60 to 80%. After the humidity conditioning, the overcoat layer is preferably released from the temporary support under the same condition as that at the humidity conditioning described above. The condition is preferably at temperature from 18 to 28°C and relative humidity from 55 to 85%, and particularly preferably at temperature from 20 to 25°C and relative humidity from 60 to 80%.

The overcoat layer released is laminated by contacting it on the image-recording layer provided on a support. Temperature at the laminating is preferably in a range from 10 to 200°C. After the contact, the overcoat layer may be pressed by applying pressure.

[Image-recording layer]

Next, the constituting components of the image-recording layer will be described in detail.

The image-recording layer for use in the invention contains a sensitizing dye, a polymerization initiator and a polymerizable compound and an unexposed area of the image-recording layer is capable of being removed by supplying after exposure, printing ink and/or dampening water on a printing machine. The respective components which can be incorporated into the image-recording layer will be described in order below.

(A) Sensitizing dye

The sensitizing dye absorbs light at the image exposure to form the excited state and provides energy to a polymerization initiator described hereinafter with electron transfer, energy transfer or heat generation thereby improving the polymerization initiation function. Particularly, a sensitizing dye having an absorption maximum in a range from 750 to 1,400 nm is used.

The sensitizing dye having an absorption maximum in a wavelength range from 750 to 1,400 (hereinafter, also referred to as an "infrared absorbing agent") used in the invention is described in detail below. The infrared absorbing agent used is a dye.

The infrared absorbing dye has a function of converting the infrared ray absorbed to heat and a function of being excited by the infrared ray to perform electron transfer and/or energy transfer to a polymerization initiator described hereinafter. The infrared absorbing dye for use in the invention is a dye having an absorption maximum in a wavelength range from 750 to 1,400 nm.

As the infrared absorbing dye, compounds described in Paragraph Nos. [0058] to [0087] of JP-A-2008-195018 can be used.

Of the dyes, a cyanine dye, a squarylium dye, a pyrylium dye and a nickel thiolate complexes are particularly preferred. As the particularly preferred example of the dye, a cyanine dye represented by formula (a) shown below is exemplified.

Formula (a)

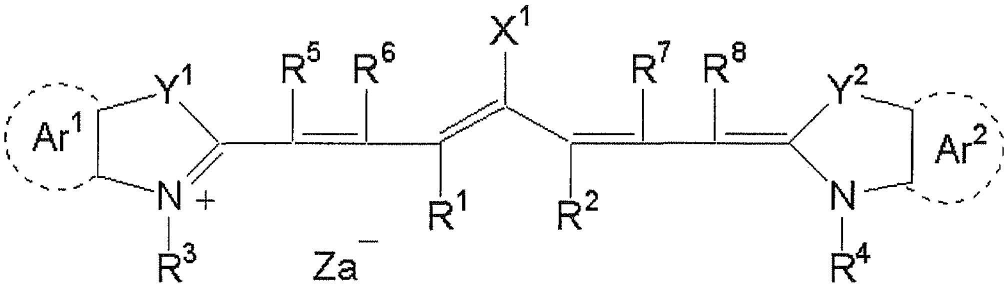

In formula (a), $X^1$ represents a hydrogen atom, a halogen atom, $-N(R^9)(R^{10})$, $X^2$-$L^1$ or a group shown below. $R^9$ and $R^{10}$, which may be the same or different, each represents an aromatic hydrocarbon group having from 6 to 10 carbon atoms, which may have a substituent, an alkyl group having from 1 to 8 carbon atoms, which may have a substituent or a hydrogen atom, or $R^9$ and $R^{10}$ may be combined with each other to form a ring. Among them, a phenyl group is preferred. $X^2$ represents an oxygen atom or a sulfur atom, $L^1$ represents a hydrocarbon group having from 1 to 12 carbon atoms, an aromatic ring group containing a hetero atom or a hydrocarbon group having from 1 to 12 carbon atoms and containing a hetero atom. The hetero atom as used herein indicates a nitrogen atom, a sulfur atom, an oxygen atom, a halogen atom or a selenium atom. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

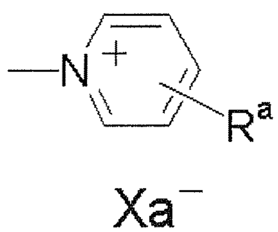

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. It is particularly preferred that $R^1$ and $R^2$ are combined with each other to form a 5-membered or 6-membered ring.

$Ar^1$ and $Ar^2$, which may be the same or different, each represents an aromatic hydrocarbon group which may have a substituent. Preferred examples of the aromatic hydrocarbon group include a benzene ring group and a naphthalene ring group. Also, preferred examples of the substituent include a hydrocarbon group having 12 or less carbon

atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion.

Specific examples of the cyanine dye represented by formula (a), which can be preferably used in the invention, include those described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638.

The infrared absorbing dyes may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the sensitizing dye in the image-recording layer according to the invention is preferably from 0.1 to 10.0% by weight, more preferably from 0.5 to 5.0% by weight, based on the total solid content of the image-recording layer.

(B) Polymerization initiator

The polymerization initiator (B) for use in the invention indicates a compound which initiates or accelerates polymerization of a polymerizable compound (C). The polymerization initiator for use in the invention includes, for example, known thermal polymerization initiators, compounds containing a bond having small bond dissociation energy and photopolymerization initiators.

The polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 are used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S.I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848 and JP-A-2008-195018, sulfonium salts described in European Patents 370,693, 390,214, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), arsonium salts described in C. S. Wen et al., Teh, Proc. Conf. Rad. Curing

ASIA, p. 478, Tokyo, Oct. (1988), and azinium salts described in JP-A-2008-195018 are exemplified.

Of the radical polymerization initiators described above, the onium salt, in particular, the iodonium salt, the sulfonium salt or the azinium salt is more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The polymerization initiator can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

(C) Polymerizable compound

The polymerizable compound (C) for use in the invention is an addition-polymerizable compound having at least one ethylenically unsaturated double bond, and it is preferably selected from compounds having at least one, preferably two or more, terminal ethylenically unsaturated double bonds. Such compounds are widely known in the field of art and they can be used in the invention without any particular limitation. The compound means, for example, a monomer or a prepolymer, specifically, a dimer, a trimer or an oligomer, and is a polymerizable compound having a molecular weight of 1,000 or less.

Specific examples of the radical polymerizable compound include compounds described in Paragraph Nos. [0089] to [0098] of JP-A-2008-195018. Among them, esters of aliphatic polyhydric alcohol compound with an unsaturated carboxylic acid (for example, acrylic acid, methacrylic acid, itaconic acid, crotonic acid, isocrotonic acid or maleic acid) are preferably exemplified. Other preferred radical polymerizable compounds include polymerizable compounds containing an isocyanuric acid structure described in JP-A-2005-329708.

Of the compounds described above, isocyanuric acid ethylene oxide-modified acrylates, for example, tris(acryloyloxyethyl) isocyanurate or bis(acryloyloxyethyl)hydroxyethyl isocyanurate are particularly preferred, because they are excellent in balance between hydrophilicity relating to the on-press development property and polymerization ability relating to the printing durability.

In the invention, the polymerizable compound (C) is preferably used in an amount from 5 to 80% by weight, more preferably from 15 to 75% by weight, based on the total solid content of the image-recording layer.

(D) Other components

The image-recording layer according to the invention may further contain other components, if desired.

(1) Binder polymer

In the image-recording layer according to the invention, a binder polymer can be used for the purpose of improving film strength of the image-recording layer. The binder polymer which can be used in the invention can be selected from those heretofore known without restriction, and polymers having a film-forming property are preferred. Among them, an acrylic resin, a polyvinyl acetal resin or a polyurethane resin is preferred.

As the binder polymer preferred for the invention, a polymer having a crosslinkable functional group for improving

film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the development property, particularly, the on-press development property in case of conducting on-press development, to the image-recording layer. In particular, coexistence of the crosslinkable group and the hydrophilic group makes it possible to maintain compatibility between the printing durability and development property.

The hydrophilic group includes, for example, a hydroxy group, a carboxyl group, an oxyalkylene structure, an amino group, an ammonium group, an amido group, a sulfo group and a phosphoric acid group. Among them, a polyoxyalkylene structure containing an alkylene oxide unit having 2 or 3 carbon atoms is preferred, and a number of oxyalkylene repeating unit is more preferably from 2 to 9.

In order to introduce a hydrophilic group into the binder polymer, a monomer having the hydrophilic group is copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate is copolymerized.

Specific examples (1) to (11) of the binder polymer for use in the invention are set forth below, but the invention should not be construed as being limited thereto. The ratio of the repeating units is indicated as a molar ratio.

(1) 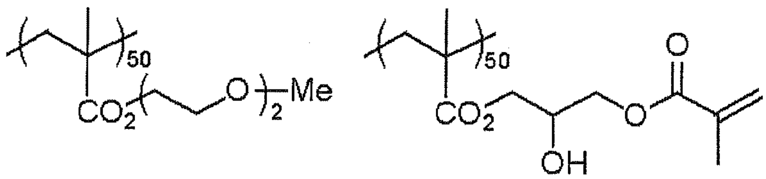

(2) 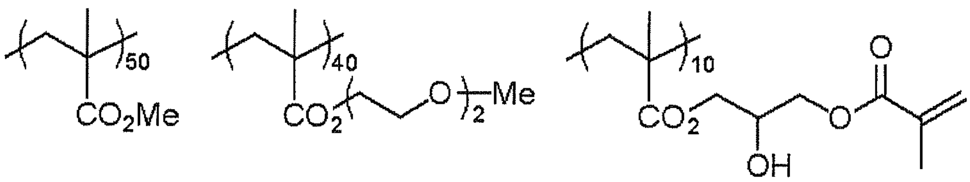

(3) 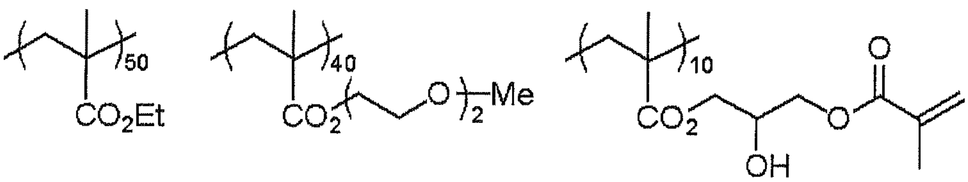

(4) 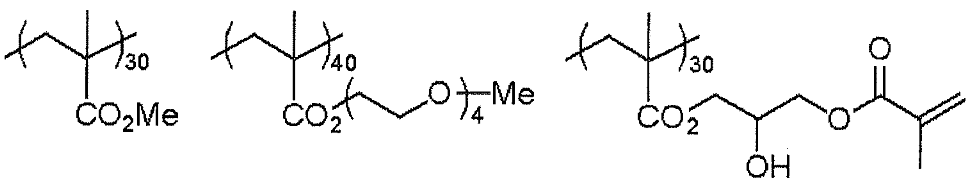

(5) 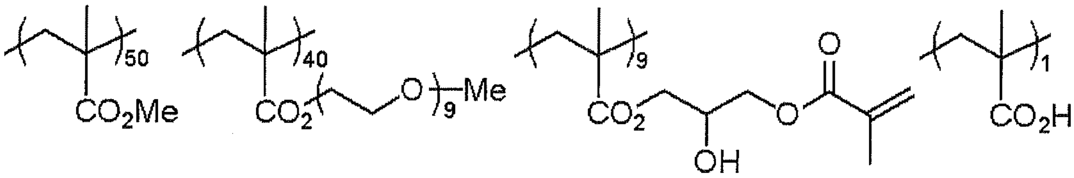

(6) 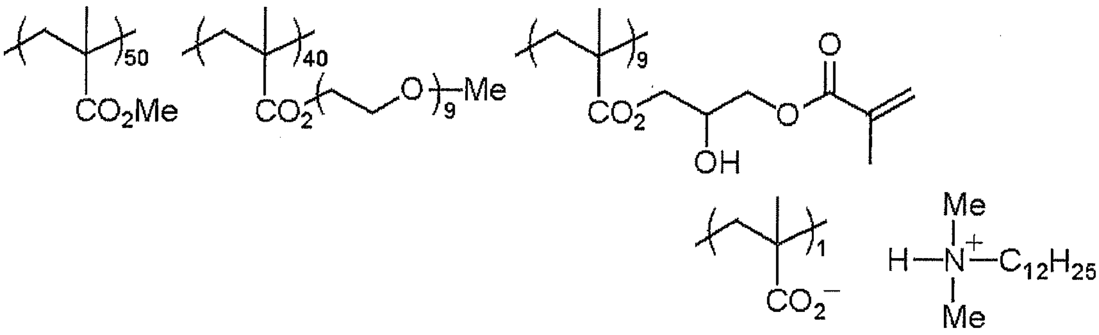

(7) 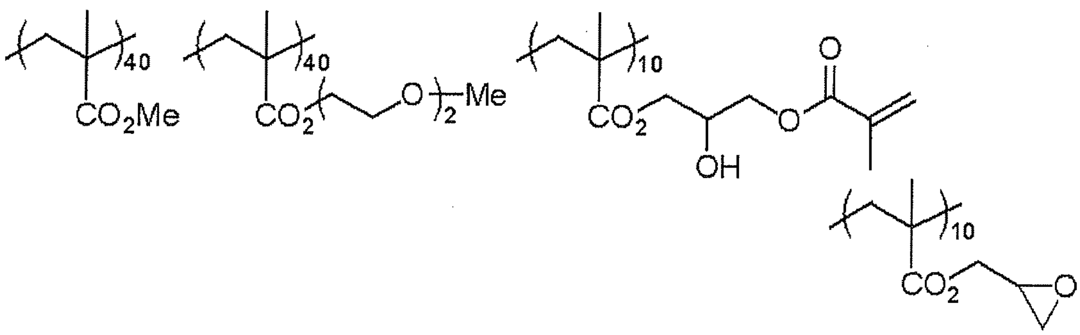

(8) 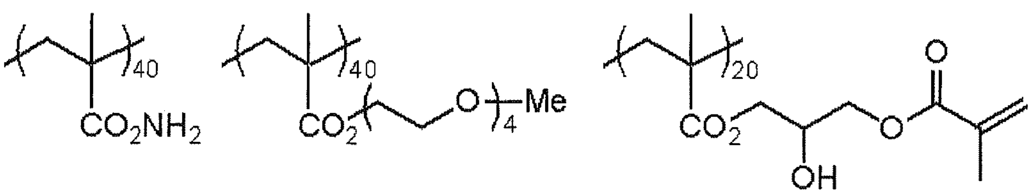

(9) 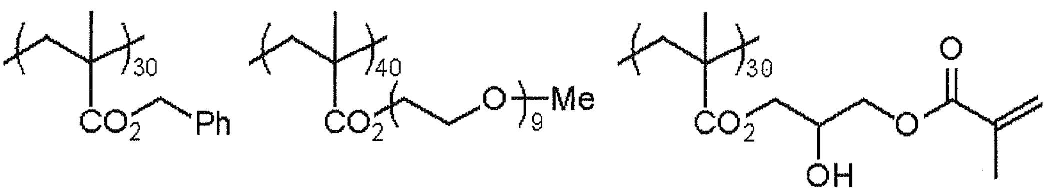

(10) 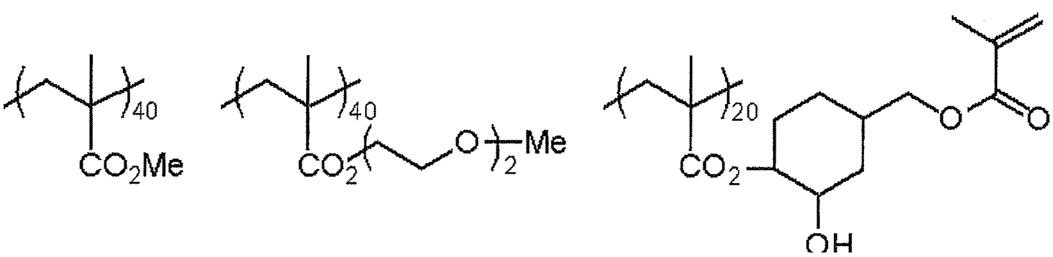

(11) 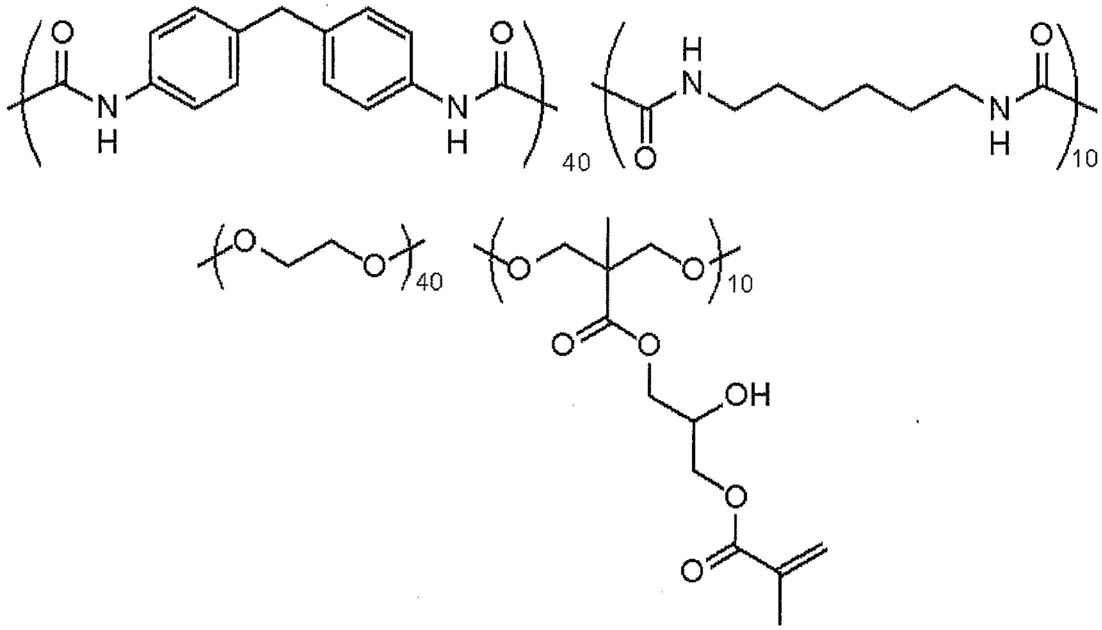

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily preferably from 5 to 90% by weight, more preferably from 5 to 80% by weight, still more preferably from 10 to 70% by weight, based on the total solid content of the image-recording layer.

(2) Hydrophobilizing precursor

According to the invention, a hydrophobilizing precursor can be used in order to improve the on-press development property. The hydrophobilizing precursor according to the invention means a fine particle capable of converting the image-recording layer to be hydrophobic when heat is applied. The fine particle is preferably at least one fine particle selected from a hydrophobic thermoplastic polymer fine particle, a thermo-reactive polymer fine particle, a microcapsule having a hydrophobic compound encapsulated and a microgel (crosslinked polymer fine particle). Among them, a polymer fine particle having a polymerizable group and a microgel are preferred.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 $\mu$m.

The thermo-reactive polymer fine particle for use in the invention includes a polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino

group or a hydroxy group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the polymerizable compound (C) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 $\mu$m, more preferably from 0.05 to 2.0 $\mu$m, particularly preferably from 0.10 to 1.0 $\mu$m. In the range described above, good resolution and good time-lapse stability can be achieved.

The content of the hydrophobilizing precursor is preferably in a range from 5 to 90% by weight based on the total solid content of the image-recording layer.

(3) Hydrophilic low molecular weight compound

The image-recording layer according to the invention may contain a hydrophilic low molecular weight compound in order to improve the development property, especially the on-press development property in case the on-press development is conducted, without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerine, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetradecosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 10% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(4) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an overcoat layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

The ammonium group-containing polymer may be any polymer containing an ammonium group in its structure and is preferably a polymer containing from 5 to 80% by mole of (meth)acrylate having an ammonium group in its side chain as a copolymerization component.

As to the ammonium salt-containing polymer, its reduced specific viscosity value (unit: cSt/g/ml) determined according to the measuring method described below is preferably from 5 to 120, more preferably from 10 to 110, particularly preferably from 15 to 100.

<Measuring method of reduced specific viscosity>

In a 20 ml measuring flask was weighed 3.33 g of a 30% by weight polymer solution (1 g as a solid content) and the measuring flask was filled up to the gauge line with N-methyl pyrrolidone. The resulting solution was put into an Ubbelohde viscometer (viscometer constant: 0.010 cSt/s) and a period for running down of the solution at 30°C was measured. The viscosity was determined in a conventional manner according to the following calculating formula:

$$\text{Kinetic viscosity} = \text{Viscometer constant} \times \text{Period for liquid to pass through a capillary (sec)}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90)
(2) 2-(Trimethylammonio)ethyl methacrylate hexafluorophosphate /3,6-dioxaheptyl methacrylate copolymer (molar ratio: 20/80)
(3) 2-(Ethyldimethylammonio)ethyl methacrylate p-toluenesulfonate/hexyl methacrylate copolymer (molar ratio: 30/70)
(4) 2-(Trimethylammonio)ethyl methacrylate hexafluorophosphate /2-ethylhexyl methacrylate copolymer (molar ratio: 20/80)
(5) 2-(Trimethylammonio)ethyl methacrylate methylsulfate/hexyl methacrylate copolymer (molar ratio: 40/60)
(6) 2-(Butyldimethylammonio)ethyl methacrylate hexafluorophosphate/3,6-dioxaheptyl methacrylate copolymer (molar ratio: 20/80)
(7) 2-(Butyldimethylammonio)ethyl acrylate hexafluorophosphate/3,6-dioxaheptyl methacrylate copolymer (molar ratio: 20/80)
(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(5) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

(E) Formation of image-recording layer

The image-recording layer according to the invention is formed by dissolving or dispersing each of the necessary components described above in a solvent to prepare a coating solution for image-recording layer and coating the solution on an appropriate support. The solvent used includes, for example, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto.

The solvents may be used individually or as a mixture. The solid content concentration of the coating solution is preferably from 1 to 50% by weight.

As to the image-recording layer according to the invention, it is also possible to form the image-recording layer by preparing plural coating solutions by dispersing or dissolving the same or different constituting components described above into the same or different solvents and conducting repeatedly the coating and drying plural times.

The coating amount (solid content) of the image-recording layer formed on a support after coating and drying may be varied according to the intended purpose but is ordinarily preferably from 0.3 to 3.0 $g/m^2$. In the range described above, good sensitivity and good film property of the image-recording layer can be achieved.

Various methods can be used for the coating. Examples of the coating method include bar coater coating, spin coating, spray coating, curtain coating, dip coating, air knife coating, blade coating and roll coating.

[Support]

As the support for use in the invention, a dimensionally stable aluminum or its alloy (for example, an alloy with silicon, copper, manganese, magnesium, chromium, zinc, lead, bismuth or nickel) is employed. Ordinarily, conventionally known materials described in Aluminum Handbook, Fourth edition (1990, published by Japan Light Metal Association), for example, JIS A 1050 material, JIS A 1100 material, JIS A 3103 material, JIS A 3004 material, JIS A 3005 material or alloys prepared by adding not less than 0.1% by weight of magnesium into these materials for the purposes of increasing tensile strength are used. In case of the on-press development type lithographic printing plate precursor containing a polymerizable compound, an aluminum alloy containing from 0.08 to 0.45% by weight of Fe and from 0.05 to 0.20% by weight of Si and having an Al-Fe type intermetallic compound content of not more than 0.05% by weight is preferably used.

When the support is an aluminum plate, it is ordinary that its surface is subjected to various treatments depending on the purposes. According to an ordinary treatment method, the aluminum plate is subjected to degreasing or to an electrolytic polishing treatment and a desmut treatment to clean the surface of the aluminum plate. Subsequently, the aluminum plate is subjected to a mechanical roughening treatment or/and an electrochemical roughening treatment to form fine irregularities on the surface thereof. Further, a chemical etching treatment and a desmut treatment are additionally conducted in some cases. Subsequently, in order to increase an abrasion resistance of the surface of the aluminum plate, the aluminum plate is subjected to an anodizing treatment and then, if desired, a hydrophilizing treatment and/or a sealing treatment are conducted on the surface of the aluminum plate.

As the support for use in the lithographic printing plate precursor according to the invention, an aluminum plate subjected to roughening treatment and anodizing treatment according to a known method is preferred. Also, other treatments, for example, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired. The support preferably has a center line average roughness from 0.10 to 1.2 μm.

[Backcoat layer]

Then, a backcoat layer composed of an organic polymer compound for preventing the occurrence of scratch in the photosensitive composition layer when stacked (for example, a backcoat layer containing an organic polymer compound described in JP-A-5-45885 or a backcoat layer containing an alkoxy compound of silicon described in JP-A-6-35174) is provided, if desired.

[Undercoat layer]

Then, a coating solution for undercoat layer is coated on the surface of the support and dried to from an undercoat layer, if desired. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As a compound for use in the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified. A polymer resin having an adsorbing group capable of adsorbing to a surface of the support, a hydrophilic group and a crosslinkable group as described in JP-A-2005-125749 and JP-A-2006-188038 is more preferably exemplified. The polymer resin is preferably a copolymer of a monomer having an adsorbing group, a monomer having a hydrophilic group and a monomer having a crosslinkable group. More specifically, a polymer resin which is a copolymer of a monomer having an adsorbing group, for example, a phenolic hydroxy group, a carboxyl group, $-PO_3H_2$, $-OPO_3H_2$, $-CONHSO_2-$, $-SO_2NHSO_2-$ and $-COCH_2COCH_3$, a monomer having a hydrophilic sulfo group and a monomer having a polymerizable crosslinkable group, for example, a methacryl group or an allyl group. The polymer resin may contain a crosslinkable group introduced by a salt formation between a polar substituent of the polymer resin and a compound containing a substituent having a counter charge to the polar substituent of the polymer resin and an ethylenically unsaturated bond and also may be further copolymerized with a monomer other than those described above, preferably a hydrophilic monomer.

The content of the unsaturated double bond in the polymer resin for undercoat layer is preferably from 0.1 to 10.0 mmol, most preferably from 2.0 to 5.5 mmol, based on 1 g of the polymer resin.

The weight average molecular weight of the polymer resin for undercoat layer is preferably 5,000 or more, more preferably from 10,000 to 300,000.

The undercoat layer is coated and dried according to a known method. The coating amount (solid content) of the undercoat layer is preferably from 0.1 to 100 $mg/m^2$, and more preferably from 1 to 30 $mg/m^2$.

[Plate making method]

The plate making method of the lithographic printing plate precursor according to the invention is preferably a method of development (on-press development) on a printing machine while supplying dampening water and/or ink.

The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing is performed using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

The plate making method is described in more detail below.

The desirable wavelength of the exposure light source used in the image exposure according to the invention is preferably from 300 to 450 nm or from 750 to 1,400 nm. In case of exposing with light of 300 to 450 nm, the lithographic printing plate precursor having an image-recording layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light

source of 750 to 1,400 nm, a solid laser or semiconductor laser emitting an infrared ray is preferably used. The exposure mechanism may be any of an internal drum system, an external drum system and a flat bed system.

With respect to the infrared ray laser, the output is preferably 100 mW or more, the exposure time per pixel is preferably within 20 microseconds, and the irradiation energy is preferably from 10 to 300 mJ/$cm^2$. With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres on the revealed hydrophilic surface and the printing ink adheres to the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

Further, the lithographic printing plate precursor according to the invention can also be developed by an automatic developing machine stocked therein an aqueous solution containing, for example, a surfactant and/or a water-soluble resin.

## EXAMPLES

The present invention will be described in detail with reference to the following examples, but the invention should not be construed as being limited thereto. With respect to a polymer compound, unless otherwise specified, a molecular weight of the polymer compound means a weight average molecular weight (Mw) and a ratio of repeating units is indicated as a mole percent.

### Examples 1 to 8 and Comparative Examples 1 to 3

1. Preparation of Lithographic printing plate precursors (1) to (7)

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/$cm^3$) of pumice having a median size of 25 $\mu$m, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current, and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/$dm^2$ in terms of the quantity of electricity when the aluminum plate functioned as an anode. The plate was then washed with water by spraying.

The plate was then subjected to an anodizing treatment using as an electrolytic solution, a 15% by weight sulfuric acid (containing 0.5% by weight of aluminum ion) at a current density of 15 A/dm$^2$ to form a direct current anodized film of 2.5 g/m$^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m$^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) described above so as to have a dry coating amount of 20 mg/m$^2$ and dried in a hot air drying machine at 80°C for 10 seconds to prepare a support having an undercoat layer for using in the experiments described below.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

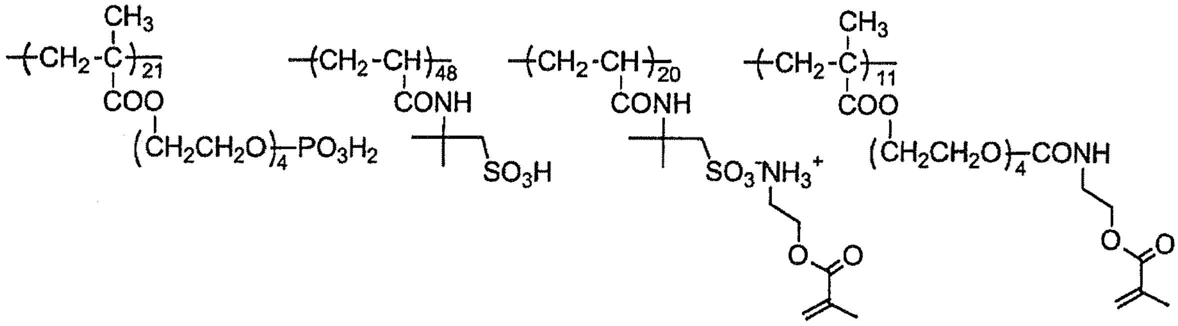

(Mw: 100,000)

Compound (1) for undercoat layer

(3) Formation of Image-recording layer

Coating solution (1) for image-recording layer having the composition shown below was coated on the undercoat layer formed as described above using a bar coater and oven-dried in a hot air drying machine at 100°C for 60 seconds to form an image-recording layer having a dry coating amount of 1.0 g/m$^2$. Coating solution (1) for image-recording layer was prepared by mixing Photosensitive solution (1) shown below with Microgel solution (1) shown below just before the coating, followed by stirring.

<Photosensitive solution (1)>

| | |
|---|---|
| Binder polymer (1) having structure shown below | 0.240 g |
| Infrared absorbing dye (1) having structure shown below | 0.030 g |
| Radical polymerization initiator (1) having structure shown below | 0.162 g |
| Polymerizable compound (Tris(acryloyloxyethyl) isocyanurate (NK ESTER A-9300, produced by Shin-Nakamura Chemical Co., Ltd.)) | 0.192 g |

(continued)

| | |
|---|---|
| Hydrophilic low molecular weight compound (Tris(2-hydroxyethyl) isocyanurate) | 0.062 g |
| Hydrophilic low molecular weight compound (1) having structure shown below | 0.050 g |
| Ammonium group-containing polymer having structure shown below (reduced specific viscosity: 44 ml/g) | 0.035 g |
| Fluorine-based surfactant (1) having structure shown below | 0.008 g |
| 2-Butanone | 1.091 g |
| 1-Methoxy-2-propanol | 8.609 g |

<Microgel solution (1)>

| | |
|---|---|
| Microgel (1) shown below | 2.640 g |
| Distilled water | 2.425 g |

The structures of Binder polymer (1), Polymerization initiator (1), Infrared absorbing dye (1), Hydrophilic low molecular weight compound (1), Fluorine-based surfactant (1) and Ammonium group-containing polymer, and preparation method of Microgel (1) are shown below.

<Preparation of Microgel (1)>

An oil phase component was prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of KURARAY POVAL PVA-205 (polyvinyl alcohol, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 μm.

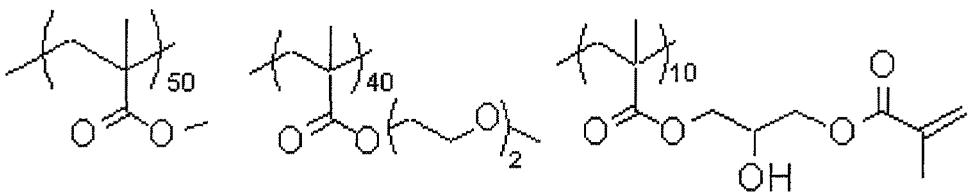

(Mw: 70,000)

Binder polymer (1)

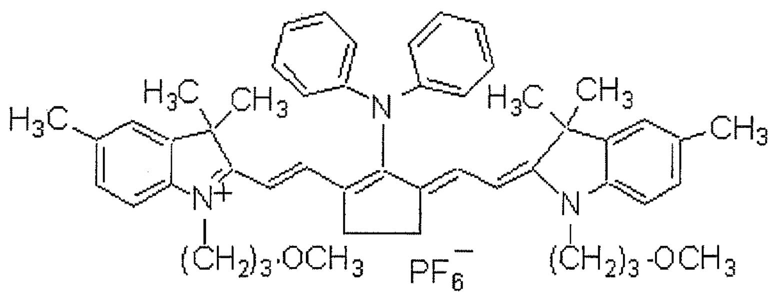

Infrared absorbing dye (1)

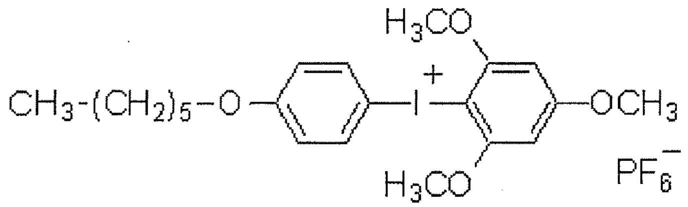

Radical polymerization initiator (1)

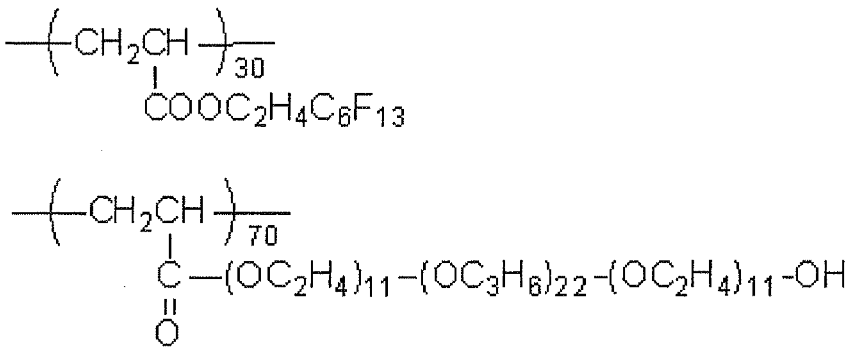

(Mw: 13,000)

Fluorine-based surfactant (1)

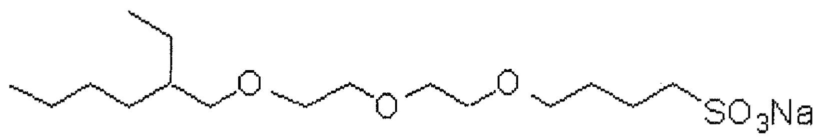

Hydrophilic low molecular weight compound (1)

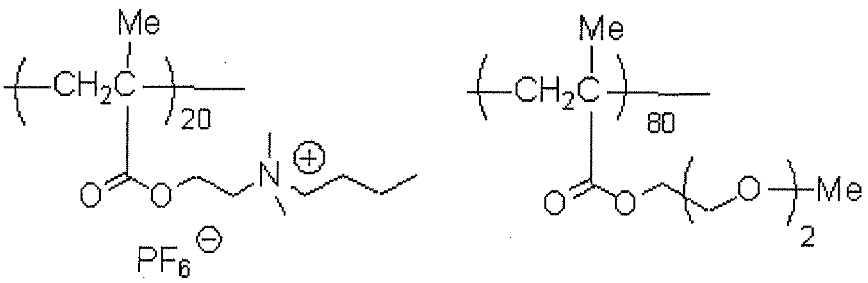

Ammonium group-containing polymer

(4) Formation of Overcoat layer

Coating solutions (1) to (7) for overcoat layer having the composition shown in the table below was coated on a polypropylene film by a bar coater and dried with hot air at 150°C for 20 seconds to form overcoat layers having the intended dry coating amount shown in the table below, respectively. After performing humidity conditioning of the coated films under 25°C and 65% RH, the overcoat layers were separated from the polypropylene films.

Each of the overcoat layers prepared from Coating solutions (1) to (7) for overcoat layer was placed on the image-recording layer prepared above and pressed by applying a pressure of 0.8 $Kg/cm^2$ under 25°C and 65% RH to prepare each of Lithographic printing plate precursors (1) to (7) for Examples 1 to 7.

TABLE 1: Coating Solutions (1) to (7) for Overcoat Layer

| | Dispersion (1) of Inorganic Stratiform Compound | Polyvinyl Alcohol (CKS 50, produced by Nippon Synthetic Chemical Industry Co., Ltd.) | Polyvinyl Alcohol (PVA-405, produced by Kuraray Co., Ltd.) | Surfactant (EMALEX 710, produced by Nihon Emulsion Co., Ltd.) | Ion-exchanged Water | Coating Amount ($g/m^2$) |
|---|---|---|---|---|---|---|
| Coating Solution (1) | 0.00 | 0.014 | 0.043 | 0.0022 | 6.50 | 0.20 |
| Coating Solution (2) | 0.00 | 0.028 | 0.085 | 0.0043 | 6.50 | 0.40 |
| Coating Solution (3) | 0.00 | 0.055 | 0.170 | 0.0086 | 6.35 | 0.80 |
| Coating Solution (4) | 0.00 | 0.069 | 0.213 | 0.0108 | 6.30 | 1.00 |
| Coating Solution (5) | 0.00 | 0.138 | 0.425 | 0.0215 | 6.00 | 2.00 |
| Coating Solution (6) | 0.25 | 0.055 | 0.170 | 0.0086 | 6.35 | 0.80 |
| Coating Solution (7) | 0.50 | 0.055 | 0.170 | 0.0086 | 6.30 | 0.80 |
| (unit of each component is indicated by parts by weight) | | | | | | |

(Preparation of Dispersion (1) of inorganic stratiform compound)

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the particle thus-dispersed was 100 or more.

2. Preparation of Lithographic printing plate precursor (8)

Lithographic printing plate precursor (8) for Example 8 was prepared in the same manner as in Lithographic printing plate precursor (3) for Example 3 except for using polyvinyl pyrrolidone (K30, produced by Wako Pure Chemical Industries, Ltd.) in place of the polyvinyl alcohol (CKS 50, produced by Nippon Synthetic Chemical Industry Co., Ltd.) in Coating solution (3) for overcoat layer.

3. Preparation of Lithographic printing plate precursors for comparative examples

Lithographic printing plate precursors for Comparative examples 1 to 3 were prepared in the same manner as in the preparation method of the lithographic printing plate precursor for Example 1 except that Coating solutions (1), (3) and (7) for overcoat layer were coated on the image-recording layer prepared above and dried with hot air at 150°C for 20 seconds to form overcoat layers having the intended dry coating amount, respectively.

4. Evaluation of Lithographic printing plate precursor

(1) Interlayer mixing ratio of overcoat layer

The interlayer mixing ratio of overcoat layer was determined according to the measuring method of interlayer mixing ratio described above. The exposure was performed after vacuuming at 30 mmHg using a horizontal type vacuum printer P-806-G (produced by Dainippon Screen Mfg. Co., Ltd.) at an exposure count of 400 so as that a reaction rate of polymerizable group reaches 60% or more.

(2) Ink receptivity

The lithographic printing plate precursor was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (DP 193 (produced by FFHB)/tap water = 3/97 (volume ratio)) and PANTONE BLAU 072C (produced by EPPLE), the dampening water and ink were supplied according to the standard automatic printing start method of LITHRONE 26 to conduct on-press development and then printing on 1,000 sheets of TOKUBISHI art paper (76.5 kg) at a printing speed of 10,000 sheets per hour.

A number of the printing papers required until reaching a state where the ink was transferred into the image area of the image-recording layer was measured to evaluate the ink receptivity. The results obtained are shown in Table 2.

(3) Printing durability

The lithographic printing plate precursor was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct on-press development and then printing on TOKUBISHI art paper (76.5 kg) at a printing speed of 10,000 sheets per hour. As the increase in a number of printing papers, the image-recording layer was gradually abraded to cause decrease in the ink density on the printed material. A number of printing papers wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 2.

TABLE 2: Examples 1 to 8 and Comparative Examples 1 to 3

| | Interlayer Mixing Ratio of Overcoat Layer (%) | Ink Receptivity (sheets) | Printing Durability ($\times 10^4$ sheets) |
|---|---|---|---|
| Example 1 | 2 % | 20 | 4.5 |
| Example 2 | 2 % | 25 | 5.0 |
| Example 3 | 2 % | 30 | 5.2 |
| Example 4 | 2 % | 45 | 5.6 |
| Example 5 | 3 % | 70 | 6.0 |
| Example 6 | 1 % | 35 | 6.0 |
| Example 7 | 1 % | 30 | 6.5 |
| Example 8 | 4 % | 35 | 5.0 |

(continued)

| | Interlayer Mixing Ratio of Overcoat Layer (%) | Ink Receptivity (sheets) | Printing Durability ($\times 10^4$ sheets) |
|---|---|---|---|
| Comparative Example 1 | 40 % | 200 | 1.0 |
| Comparative Example 2 | 19 % | 350 | 0.8 |
| Comparative Example 3 | 14 % | 400 | 2.5 |

From the results shown in Table 2, the more improvement of printing durability is recognized without accompanying the deterioration of ink receptivity, in the case where the mixing ratio of the overcoat layer to the image-recording layer is small so as 10% or less. Further, in the case where the overcoat layer contains the inorganic particle (mica), also, the significant deterioration of ink receptivity which is a problem heretofore observed is not recognized and the improvement in printing durability is found.

INDUSTRIAL APPLICABILITY

According to the present invention, an on-press development type lithographic printing plate precursor excellent in ink receptivity and printing durability and a method of producing thereof can be provided.

Although the invention has been described in detail and by reference to specific embodiments, it is apparent to those skilled in the art that it is possible to add various modifications insofar as the modifications do not deviate from the scope of the claims.

### Claims

1. A lithographic printing plate precursor which comprises a support, an image-recording layer which contains a sensitizing dye which is an infrared-absorbing dye, a polymerization initiator and a polymerizable compound and an unexposed area of which is capable of being removed by supplying after exposure, at least one of printing ink and dampening water on a printing machine, and an overcoat layer containing a water-soluble resin in this order, wherein the mixing ratio of the overcoat layer to the image-recording layer is 10% or less.

2. The lithographic printing plate precursor as claimed in Claim 1, wherein the water-soluble resin is a polyvinyl alcohol resin.

3. The lithographic printing plate precursor as claimed in Claim 1 or 2, wherein the overcoat layer contains an inorganic stratiform compound.

4. The lithographic printing plate precursor as claimed in Claim 3, wherein the inorganic stratiform compound is mica.

5. The lithographic printing plate precursor as claimed in any one of Claims 1 to 4, wherein the image-recording layer further contains a polymer binder having a polyoxyalkylene structure.

6. A method of producing a lithographic printing plate precursor comprising: providing, on a support, an image-recording layer which contains a sensitizing dye which is an infrared-absorbing dye, a polymerization initiator and a polymerizable compound and an unexposed area of which is capable of being removed by supplying after exposure, at least one of printing ink and dampening water on a printing machine; and further dry laminating an overcoat layer containing a water-soluble resin, wherein the dry laminating of the overcoat layer involves the steps of: coating and drying the overcoat layer on a temporary support, releasing the overcoat layer from the temporary support by subjecting it to humidity conditioning and contacting the released overcoat layer on the image-recording layer.

## Patentansprüche

1. Lithographiedruckplattenvorläufer, der einen Träger, eine Bildaufzeichnungsschicht, die einen Sensibilisierungsfarbstoff, der ein infrarotabsorbierender Farbstoff ist, einen Polymerisationsinitiator und eine polymerisierbare Verbindung enthält, und wobei ein nicht-belichteter Bereich hiervon in der Lage ist, durch Zuführen von zumindest einem von Drucktinte und Anfeuchtwasser auf einer Druckmaschine nach der Belichtung entfernt zu werden, und eine Überzugsschicht, die ein wasserlösliches Harz enthält, in dieser Reihenfolge umfasst, worin das Mischungsverhältnis der Überzugsschicht zur Bildaufzeichnungsschicht 10 % oder weniger beträgt.

2. Lithographiedruckplattenvorläufer gemäß Anspruch 1, worin das wasserlösliche Harz ein Polyvinylalkohol-Harz ist.

3. Lithographiedruckplattenvorläufer gemäß Anspruch 1 oder 2, worin die Überzugsschicht eine anorganische Schichtverbindung enthält.

4. Lithographiedruckplattenvorläufer gemäß Anspruch 3, worin die anorganische Schichtverbindung Glimmer ist.

5. Lithographiedruckplattenvorläufer gemäß irgendeinem der Ansprüche 1 bis 4, worin die Bildaufzeichnungsschicht ferner ein Polymer-Bindemittel mit einer Polyoxyalkylenstruktur enthält.

6. Verfahren zur Herstellung eines Lithographiedruckplattenvorläufers, umfassend: Bereitstellen einer Bildaufzeichnungsschicht auf einem Träger, die einen Sensibilisierungsfarbstoff, der ein infrarotabsorbierender Farbstoff ist, einen Polymerisationsinitiator und eine polymerisierbare Verbindung enthält, und wovon ein nicht-belichteter Bereich durch Zuführen von zumindest einem von Drucktinte und Anfeuchtwasser auf einer Druckmaschine nach der Belichtung entfernt werden kann; und ferner Trockenlaminieren einer Überzugsschicht, die ein wasserlösliches Harz enthält, worin das Trockenlaminieren der Überzugsschicht den Schritt umfasst: Beschichten und Trocknen der Überzugsschicht auf einem temporären Träger, Ablösen der Überzugsschicht von dem temporären Träger durch Unterziehen hiervon durch Feuchtigkeitskonditionierung, und Inkontaktbringen der abgelösten Überzugsschicht auf die Bildaufzeichnungsschicht.

## Revendications

1. Précurseur de plaque d'impression lithographique qui comprend un support, une couche d'enregistrement d'image qui contient un colorant de sensibilisation qui est un colorant absorbant les infrarouges, un initiateur de polymérisation et un composé polymérisable et dont une zone non exposée est capable d'être éliminée en fournissant après exposition, au moins l'une parmi une encre d'impression et une eau de mouillage sur une machine d'impression, et une couche de revêtement contenant une résine hydrosoluble dans cet ordre, dans lequel le rapport de mélange entre la couche de revêtement et la couche d'enregistrement d'image est de 10 % ou moins.

2. Précurseur de plaque d'impression lithographique selon la revendication 1, dans lequel la résine hydrosoluble est une résine de poly(alcool vinylique).

3. Précurseur de plaque d'impression lithographique selon la revendication 1 ou 2, dans lequel la couche de revêtement contient un composé stratiforme inorganique.

4. Précurseur de plaque d'impression lithographique selon la revendication 3, dans lequel le composé stratiforme inorganique est un mica.

5. Précurseur de plaque d'impression lithographique selon l'une quelconque des revendications 1 à 4, dans lequel la couche d'enregistrement d'image contient en outre un liant polymère ayant une structure de polyoxyalkylène.

6. Procédé de production d'un précurseur de plaque d'impression lithographique comprenant : la fourniture, sur un support, d'une couche d'enregistrement d'image qui contient un colorant de sensibilisation qui est un colorant absorbant les infrarouges, un initiateur de polymérisation et un composé polymérisable et dont une zone non exposée est capable d'être éliminée en fournissant après exposition, au moins l'une parmi une encre d'impression et une eau de mouillage sur une machine d'impression ; et en outre la stratification à sec d'une couche de revêtement contenant une résine hydrosoluble, dans lequel la stratification à sec de la couche de revêtement implique les étapes suivantes : le revêtement et le séchage de la couche de revêtement sur un support temporaire, la séparation de la

couche de revêtement à partir du support temporaire en la soumettant à de l'humidité, le conditionnement et la mise en contact de la couche de revêtement séparée sur la couche d'enregistrement d'image.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7060268 B
- JP 9034117 A
- JP 9204049 A
- JP 11311862 A
- JP 2002169272 A
- JP 2005119273 A
- EP 2042337 A1
- JP 2005280123 A
- US 3458311 A
- JP 55049729 B
- JP 2008195018 A
- JP 2001133969 A
- JP 2002023360 A
- JP 2002040638 A
- JP 8108621 A
- JP 61166544 A
- JP 2002328465 A
- US 4069055 A
- JP 4365049 A
- US 4069056 A
- EP 104143 A
- US 20080311520 A
- JP 2150848 A
- EP 370693 A
- EP 390214 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2005329708 A
- JP 9123387 A
- JP 9131850 A
- JP 9171249 A
- JP 9171250 A
- EP 931647 A
- JP 2001277740 A
- JP 2001277742 A
- JP 2006297907 A
- JP 2007050660 A
- JP 2008284817 A
- JP 2006091479 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- JP 10282679 A
- JP 2304441 A
- JP 2005125749 A
- JP 2006188038 A


### Non-patent literature cited in the description


- **S.I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- *Research Disclosure,* January 1992
- Aluminum Handbook. Japan Light Metal Association, 1990